# EUROPÄISCHE PATENTSCHRIFT

(11) **EP 3 020 073 B1**
(45) Veröffentlichungstag und Bekanntmachung des Hinweises auf die Patenterteilung: **27.10.2021**
(21) Anmeldenummer: 14738820.1
(22) Anmeldetag: 10.07.2014
(51) Int. Cl.: H01L 31/048, H01L 31/042, H02S 20/00, H02S 20/23

(54) **SOLARMODUL MIT ELEKTRISCH ISOLIERTEM MODULTRÄGER, VERFAHREN ZU DESSEN HERSTELLUNG UND VERWENDUNG EINER KLEBESCHICHT ZUR BEFESTIGUNG DES MODULTRÄGERS**
SOLAR MODULE WITH ELECTRICALLY ISOLATED MODULE SUPPORT, METHOD FOR THE PRODUCTION THEREOF AND USAGE OF A GLUE LAYER TO ATTACH SAID MODULE SUPPORT
MODULE SOLAIRE DOTÉ D'UN SUPPORT DE MODULE ÉLECTRIQUEMENT ISOLÉ, SON PROCÉDÉ DE FABRICATION ET UTILISATION D'UNE COUCHE DE COLLE POUR FIXER LEDIT SUPPORT DE MODULE

(30) Priorität: 10.07.2013 EP 13175859
(43) Veröffentlichungstag der Anmeldung: 18.05.2016
(73) Patentinhaber: (CNBM) Bengbu Design & Research Institute for Glass Industry Co., Ltd., Bengbu (CN)
(72) Erfinder: BOROWSKI, Peter, 80799 München (DE); SCHNEIDER, Oliver, 97074 Würzburg (DE)
(74) Vertreter: Evans, Huw David Duncan
(86) Internationale Anmeldenummer: PCT/EP2014/064826
(87) Internationale Veröffentlichungsnummer: WO 2015/004244

(56) Entgegenhaltungen:
- WO-A2-2013/079375
- US-A1- 2010 051 087
- US-A1- 2011 048 509
- US-A1- 2012 305 056
- FUKAE K ET AL: "Proposal of unique PV system for large-scale photovoltaic power generation system", PROCEEDINGS OF THE 3RD WORLD CONFERENCE ON PHOTOVOLTAIC ENERGY CONVERSION : JOINT CONFERENCE OF 13TH PV SCIENCE & ENGINEERING CONFERENCE, 30TH IEEE PV SPECIALISTS CONFERENCE, 18TH EUROPEAN PV SOLAR ENERGY CONFERENCE; OSAKA INTERNATIONAL CONGRESS CENT, 18. Mai 2003 (2003-05-18), Seite 2815, XP031987909, ISBN: 978-4-9901816-0-4
- STEPHAN HOFFMANN ET AL: "Effect of humidity and temperature on the potential-induced degradation", PROGRESS IN PHOTOVOLTAICS: RESEARCH AND APPLICATIONS, 15. August 2012 (2012-08-15), Seiten n/a-n/a, XP055085778, ISSN: 1062-7995, DOI: 10.1002/pip.2238
- None

## Beschreibung

Die Erfindung betrifft ein Solarmodul mit elektrisch isoliertem Modulträger sowie Verfahren zu dessen Herstellung und die Verwendung einer Klebeschicht zur Befestigung des Modulträgers.

Photovoltaische Schichtensysteme zur direkten Umwandlung von Sonnenlicht in elektrische Energie sind hinlänglich bekannt. Gemeinhin werden diese als "Solarzellen" bezeichnet, wobei sich der Begriff "Dünnschichtsolarzellen" auf Schichtensysteme mit Dicken von nur wenigen Mikrometern bezieht, die (Träger-)Substrate für eine ausreichende mechanische Festigkeit benötigen. Bekannte Substrate umfassen anorganisches Glas, Kunststoffe (Polymere) oder Metalle, insbesondere Metalllegierungen, und können in Abhängigkeit von der jeweiligen Schichtdicke und den spezifischen Materialeigenschaften als starre Platten oder biegsame Folien ausgestaltet sein.

Hinsichtlich der technologischen Handhabbarkeit und des Wirkungsgrads haben sich Dünnschichtsolarzellen mit einer Halbleiterschicht aus amorphem, mikromorphem oder polykristallinem Silizium, Cadmium-Tellurid (CdTe), Gallium-Arsenid (GaAs) oder einer Chalkopyrit-Verbindung, insbesondere Kupfer-Indium/Gallium-Dischwefel/Diselenid, abgekürzt durch die Formel Cu(In,Ga)(S,Se)₂, als vorteilhaft erwiesen. Insbesondere Kupfer-Indium-Diselenid (CuInSe₂ bzw. CIS) zeichnet sich aufgrund seines an das Spektrum des Sonnenlichts angepassten Bandabstands durch einen besonders hohen Absorptionskoeffizienten aus.

Mit einzelnen Solarzellen können typischerweise nur Spannungspegel von weniger als 1 Volt erreicht werden. Um eine technisch brauchbare Ausgangsspannung zu erhalten, werden daher eine Vielzahl Solarzellen in einem Solarmodul seriell miteinander verschaltet. Hierbei bieten Dünnschichtsolarmodule den besonderen Vorteil, dass die Solarzellen schon während der Schichtenherstellung in integrierter Form verschaltet werden können. In der Patentliteratur wurden Dünnschichtsolarmodule bereits mehrfach beschrieben. Lediglich beispielhaft sei auf DE 4 324 318 C1 und EP 2 200 097 A1 verwiesen.

In der Praxis werden Solarmodule auf die Dächer von Gebäuden montiert (Aufdach-Montage) oder bilden einen Teil der Dachhaut (Indach-Montage). Bekannt ist es auch, Solarmodule als Fassaden- oder Wandelemente einzusetzen, insbesondere in Form freiaufgestellter oder freitragender (trägerloser) Glaskonstruktionen.

Die Dachmontage von Solarmodulen erfolgt in der Regel dachparallel an einer am Dach oder einer Dachunterkonstruktion verankerten Modulhalterung. Eine solche Modulhalterung umfasst gewöhnlich ein Schienensystem aus parallelen Tragschienen, beispielsweise Aluminiumschienen, die durch Stahlanker auf Ziegeldächern oder Schrauben auf Wellplatten- oder Trapezblechdächern befestigt sind.

Es ist gängige Praxis, das Solarmodul mit einem aus Aluminium gefertigten Modulrahmen zu versehen, welcher einerseits eine mechanische Verstärkung bewirkt und andererseits für eine Montage des Solarmoduls an der Modulhalterung dienen kann.

In jüngerer Zeit werden zunehmend rahmenlose Solarmodule hergestellt, welche ein verringertes Modulgewicht haben und mit verminderten Fertigungskosten gefertigt werden können. In der Regel werden rahmenlose Solarmodule auf ihrer Rückseite mit Modulträgern aus Stahl oder Aluminium versehen, welche auf die Modulrückseite aufgeklebt werden. Wie der Modulrahmen wirken die Modulträger mechanisch verstärkend und können zur Befestigung des Solarmoduls an der Modulhalterung dienen. In beiden Fällen werden die Modulträger häufig auch als Verstärkungsstreben oder als "Backrails" bezeichnet. In der Patentliteratur sind Backrails beispielsweise in DE 10 2009057937 A1 und US 2009/0205703 A1 beschrieben.

Es ist bekannt, dass sich aufgrund unterschiedlicher elektrischer Potentiale zwischen dem Massepotential der unmittelbaren Umgebung des Solarmoduls und dem photovoltaischen Schichtenaufbau eine hohe elektrische Systemspannung von bis zu 1500 V einstellt. Typischerweise bedingt eine Erdung der Modulträger, dass die Umgebung des Solarmoduls auf Massepotential liegt. Die hohe Systemspannung führt zu hohen elektrischen Feldstärken zwischen den Modulträgern und dem photovoltaischen Schichtenaufbau. Dadurch können elektrische Transienten auftreten oder aber Ionen wie Natriumionen aus dem Glas in die dünnen Schichten des photovoltaischen Schichtenaufbaus hinein oder aus diesen heraus driften. Eine Korrosion oder Delamination der Photovoltaik-Zellen führt zur dauerhaften (potentialinduzierten) Leistungsdegradation oder zum Ausfall der Solarmodule.

Photovoltaik-Systeme erfordern zur Einspeisung von elektrischer Energie ins öffentliche Versorgungsnetz eine Schaltung von Solarmodulen und Wechselrichter zur Wandlung von Gleichspannung in Wechselspannung.

Aus DE 10 2007 050 554 A1 sind Photovoltaik-Systeme mit Potentialanhebung zur Verringerung der Leistungsdegradation im Langzeiteinsatz bekannt. Das Potential des Pluspols der Schaltung von Solarmodulen wird dabei am Wechselrichter gegen das Massepotential verschoben, sodass keine unkontrollierten elektrischen Entladungen vom Solarmodul zur Masse auftreten.

Des Weiteren sind auch Wechselrichter für Photovoltaik-Systeme bekannt, die über einen Trenntransformator die Solarmodule galvanisch von dem Potential zur Erdmasse trennen, um unkontrollierte Entladungen von dem Photovoltaik-System zur Erdmasse zu verhindern. Dabei müssen allerdings aufwändig an die Solarmodule angepasste Wechselrichter verwendet werden, die einen geringen elektrischen Wirkungsgrad aufweisen.

DE 10 2009 044 142 A1 offenbart ein Dünnschicht-Bauelement und beispielsweise ein Solarmodul auf Glas mit einer elektrisch leitfähigen Schutzvorrichtung. Dabei werden die durch ein elektrisches Feld verursachte Drift von Ionen aus der Glasscheibe und / oder elektrische Entladungen von dem funktionalen Schichtenaufbau zur elektrisch leitfähigen Schutzvorrichtung verlagert. Die Einführung der elektrisch leitfähigen Schutzvorrichtung als zusätzliches elektrisches Bauteil erschwert den Herstellungsprozess des Dünnschicht-Bauelements.

FUKAE K ET AL: "Proposal of unique PV system for large-scale photovoltaic power generation system", PROCEEDINGS OF THE 3RD WORLD CONFERENCE ON PHOTOVOL TAIC ENERGY CONVERSION: JOINT CONFERENCE OF 13TH PV SCIENCE & ENGINEERING CONFERENCE, 30TH IEEE PV SPECIALISTS CONFERENCE, 18TH EUROPEAN PV SOLAR ENERGY CONFERENCE; OSAKA INTERNATIONAL CONGRESS CENT, 18. Mai 2003 (2003-05-18), Seite 2815, XP031987909,ISBN: 978-4-9901816-0-4 zeigt ein Solarmodul, das durch einen Silikonkleber auf einen Unterbau aus Beton geklebt ist.

WO 2013079375 A2 zeigt einen rahmenloses Solarmodul mit metallischen Verstärkungsstreben, die durch einen aushärtbaren Kleber auf die Rückseite des Solarmoduls geklebt sind.

Die Aufgabe der vorliegenden Erfindung ist es, ein Solarmodul mit Modulträgern (Backrails) in vorteilhafter Weise weiterzubilden, das unabhängig von Wechselrichtern und zusätzlichen elektrischen Bauteilen gegen potentialinduzierte Leistungsdegradation geschützt ist.

Diese und weitere Aufgaben werden nach dem Vorschlag der Erfindung durch ein Solarmodul sowie ein Verfahren zur Herstellung eines Solarmoduls und die Verwendung einer Klebeschicht zur Befestigung eines Modulträgers im Solarmodul. mit den Merkmalen der nebengeordneten Patentansprüche gelöst. Vorteilhafte Ausgestaltungen der Erfindung sind durch die Merkmale der Unteransprüche angegeben.

Erfindungsgemäß ist ein Solarmodul gezeigt, welches ein Substrat und eine Deckschicht aufweist, zwischen denen sich ein Schichtenaufbau zur Formung von Solarzellen befindet. Das Substrat und die Deckschicht bestehen beispielsweise aus anorganischem Glas, Polymeren oder Metalllegierungen und sind beispielsweise als starre Platten ausgestaltet, die in einer so genannten Verbundscheibenstruktur miteinander verbunden sind.

Bei dem Solarmodul handelt es sich vorzugsweise um ein Dünnschichtsolarmodul mit vorzugsweise in integrierter Form seriell verschalteten Dünnschichtsolarzellen. Typischerweise umfasst der Schichtenaufbau eine Rückelektrodenschicht, eine Frontelektrodenschicht sowie einen Absorber. Vorzugsweise umfasst der Absorber eine Halbleiterschicht aus einer Chalkopyrit-Verbindung, bei der es sich beispielsweise um einen I-III-VI-Halbleiter aus der Gruppe Kupfer-Indium/Gallium-Dischwefel/Diselenid (Cu(In,Ga)(S,Se)₂), beispielsweise Kupfer-Indium-Diselenid (CuInSe₂ bzw. CIS) oder verwandte Verbindungen, handeln kann.

Auf der dem Schichtenaufbau abgewandten, rückseitigen Substratfläche ist wenigstens ein Modulträger zur Versteifung und/oder tragenden Montage des Solarmoduls an einer ortsfest verankerten Modulhalterung, wie einem Schienensystem, durch Verklebung befestigt. Der Modulträger erstreckt sich bevorzugt entlang den Längsseiten eines in Aufsicht rechteckförmigen Solarmoduls.

In einer vorteilhaften Ausgestaltung weist das erfindungsgemäße Solarmodul zwei oder vier Modulträger auf. Dadurch lässt sich eine sichere Befestigung des Solarmoduls bei guter Lastverteilung (beispielsweise Windlast) und geringem Materialaufwand erzielen. In der Regel ist der Modulträger aus einem anderen Material als das beispielsweise gläserne (Träger-)Substrat gefertigt, wobei erfindungsgemäß aus einem metallischen Material, beispielsweise Aluminium oder Stahl besteht. Zur Befestigung am Substrat weist der Modulträger wenigstens eine Klebefläche auf, die durch eine Klebeschicht aus einem ausgehärteten Klebstoff mit der rückseitigen Substratfläche verklebt ist.

Wesentlich hierbei ist, dass die Klebeschicht einen zumindest in ausgehärtetem Zustand elektrisch hochisolierenden Klebstoff enthält oder aus diesem besteht. Die vorteilhafte Wirkung des elektrisch hochisolierenden Klebstoffs kann in einem einfachen Modell dadurch verstanden werden, dass durch den elektrisch hochisolierenden Klebstoff eine Diffusion von Fremdatomen aus dem Substrat in den Schichtenaufbau deutlich reduziert oder nahezu vollständig vermieden wird. Dies gilt auch bei hohen Spannungsdifferenzen zwischen Modulträger und Schichtenaufbau. Es findet deshalb nur eine sehr geringe oder keine potentialinduzierte Leistungsdegradation des Solarmoduls statt.

In dem erfindungsgemäßen Solarmodul weist der Klebstoff einen spezifischen Widerstand von ≥1500 GOhm*cm, bevorzugt >4000 GOhm*cm und besonders bevorzugt von 5000 GOhm*cm bis 15000 GOhm*cm auf. Dabei ist es besonders vorteilhaft, wenn der Klebstoff diesen spezifischen Widerstand über seinen kompletten Verwendungsbereich, das heißt bei bis zu 1000 V Spannungsdifferenz zwischen Schichtenaufbau und Modulträger, bei bis zu 95°C und bei bis zu 85% relativer Luftfeuchtigkeit aufweist. Derartige elektrisch hochisolierende Klebstoffe isolieren den Modulträger von dem Substrat und dem photovoltaischen Schichtenaufbau besonders günstig und verhindern eine potentialinduzierte Leistungsdegradation besonders wirkungsvoll.

Vorteilhafte erfindungsgemäße Klebstoffe enthalten Silikonkleber, Polyurethane, (Poly-)Acrylate oder Epoxidharze. Besonders vorteilhafte erfindungsgemäße Klebstoffe enthalten einkomponentige oder zweikomponentige Silikonkleber. Derartige Klebstoffe sind besonders geeignet, da sie die erfindungsgemäßen elektrisch hochisolierenden Eigenschaften sowie eine gute Verarbeitbarkeit und eine ausreichende Festigkeit und Witterungsbeständigkeit aufweisen.

In dem erfindungsgemäßen Solarmodul beträgt die Dicke d der Klebeschicht, und insbesondere die Mindestdicke der Klebeschicht, von 1 mm bis 3 mm und besonders bevorzugt von 1,5 mm bis 2,5 mm. Derartige Dicken d isolieren den Modulträger von dem Schichtenaufbau besonders günstig und verhindern eine potentialinduzierte Leistungsdegradation besonders wirkungsvoll.

In einer weiteren vorteilhaften Ausgestaltung eines erfindungsgemäßen Solarmoduls beträgt die Klebefläche von 5% bis 20% und bevorzugt von 5% bis 10% der Substratfläche. Dies hat den besonderen Vorteil, dass der elektrische Stromfluss, der eine Natriummigration bewirken kann, auf eine kleine Fläche begrenzt bleibt.

Es hat sich gezeigt, dass die potentialinduzierte Leistungsdegradation insbesondere von der Spannungsdifferenz zwischen Schichtenaufbau und Modulträger abhängt. Die erfindungsgemäße Verringerung der Leistungsdegradation ist umso wirkungsvoller je größer die maximale Spannungsdifferenz ist. Besonders vorteilhaft ist es, wenn die maximale Spannungsdifferenz größer oder gleich 900 V, bevorzugt von 900 V bis 2000 V und besonders bevorzugt von 1400 V bis 1600 V beträgt.

In einer vorteilhaften Ausgestaltung eines erfindungsgemäßen Solarmoduls ist der Schichtenaufbau auf dem Substrat angeordnet und mit einer Zwischenschicht mit der Deckschicht verbunden. Bei dieser sogenannten Substratkonfiguration ist die potentialinduzierte Leistungsdegradation bei Solarmodulen nach dem Stand der Technik ohne elektrisch hochisolierten Klebstoff, aufgrund der räumlichen Nähe des photovoltaischen Schichtaufbaus zum Modulträger und der dadurch erhöhten elektrischen Feldstärken, besonders groß. Überraschenderweise kann durch Verwendung eines elektrisch hochisolierenden Klebstoffs die potentialinduzierte Leistungsdegradation besonders wirksam verringert werden.

In einer vorteilhaften Ausgestaltung eines erfindungsgemäßen Solarmoduls enthält oder besteht das Substrat aus Glas, bevorzugt aus Kalk-Natronglas, besonders bevorzugt mit einem minimalen Gehalt von 11 Gewichts-% Na₂O. .In einem einfachen Modell kann die potentialinduzierte Leistungsdegradation durch die Wanderung von Natriumionen aus dem Substrat in den photovoltaischen Schichtenaufbau verstanden werden. Durch die geänderte und vom optimalen Gehalt abweichende Natriumdotierung des Schichtenaufbaus sinkt die Leistung des Solarmoduls. Durch den elektrisch hochisolierenden Klebstoff wird die elektrische Feldstärke und damit auch die Wanderung von Fremdionen, wie Natriumionen, aus dem Substrat in den Schichtenaufbau oder innerhalb des Schichtenaufbaus verringert und die Leistung des Solarmoduls bleibt erhalten.

Das erfindungsgemäße Solarmodul weist keinen metallischen Rahmen auf, der zur Stabilisierung oder zur Befestigung dient. Derartige rahmenlose Solarmodule, auch Laminate genannt, werden nur über die Modulträger mit einer Erdung versehen. Da die Modulträger sehr nahe und über eine größere Fläche unterhalb des photovoltaischen Schichtenaufbaus angeordnet sind, ist die potentialinduzierte Leistungsdegradation bei Solarmodulen nach dem Stand der Technik ohne elektrisch hochisolierenden Klebstoff besonders groß. Die erfindungsgemäße Verwendung eines elektrisch hochisolierenden Klebers ist besonders wirkungsvoll und verhindert oder reduziert eine Leistungsdegradation besonders gut.

Es hat sich gezeigt, dass das Ankleben von Modulträgern am Substrat durch aushärtende Klebstoffe in der industriellen Serienfertigung oft mit einer gewissen Variabilität bezüglich des Abstands zwischen Modulträger und rückseitiger Substratfläche verbunden ist. Ursache hierfür ist die plastische Verformbarkeit des (noch) nicht ausgehärteten Klebstoffs beim Verbinden von Modulträger und Substrat. In einer vorteilhaften Ausgestaltung des erfindungsgemäßen Solarmoduls enthält die Klebeschicht ein oder mehrere Abstandshalter, die jeweils dazu ausgebildet sind, die Klebefläche des Modulträgers bei (noch) nicht ausgehärtetem Klebstoff in einem vorgebbaren Mindestabstand zur rückseitigen Substratfläche zu halten, wenn der Modulträger zur rückseitigen Substratfläche zugestellt wird, um den Modulträger durch die Klebeschicht mit der rückseitigen Substratfläche zu verbinden. Dabei ist es besonders vorteilhaft, wenn die Abstandshalter einen spezifischen elektrischen Widerstand in der Größenordnung des elektrisch hochisolierenden Klebstoffs oder größer aufweisen.

Bei einer besonders vorteilhaften Ausgestaltung des erfindungsgemäßen Solarmoduls, weist das Solarmodul keinen Rahmen an seinen Außenkanten auf, sondern wird nur durch die Modulträger auf der Modulrückseite verstärkt, stabilisiert und befestigt. Derartige rahmenlose Solarmodule sind besonders einfach und kostengünstig zu fertigen.

Bei einer weiteren vorteilhaften Ausgestaltung des erfindungsgemäßen Solarmoduls, welches in Rechteckform ausgebildet ist, erstreckt sich der mindestens eine Modulträger beispielsweise in Form einer länglichen Verstärkungsstrebe entlang den (Modul-)Längsseiten und die wenigstens eine Klebeschicht ist in Form einer gleichermaßen entlang den (Modul-)Längsseiten sich erstreckenden Klebeschicht (Kleberaupe) ausgebildet. Da Solarmodule in Fertigungsstraßen der industriellen Serienfertigung typischerweise entlang den Längsseiten verfahren werden, kann durch diese Maßnahme in vorteilhafter Weise ein seitliches Versetzen der Abstandshalter (in Modulquerrichtung) vermieden werden. Ein Herausbewegen der Abstandshalter aus der Klebeschicht durch Verfahren der Solarmodule kann somit zuverlässig und sicher vermieden werden.

Die Erfindung erstreckt sich weiterhin auf ein Verfahren zur Herstellung eines Solarmoduls, insbesondere Dünnschichtsolarmoduls, welches die folgenden Schritte umfasst:
- Bereitstellen eines Substrats und einer Deckschicht, zwischen denen sich ein Schichtenaufbau zur Formung von Solarzellen befindet,
- Bereitstellen wenigstens eines Modulträgers zur Versteifung und/oder tragenden Montage des Solarmoduls,
- Aufbringen einer Klebeschicht aus einem aushärtbaren, elektrisch hochisolierenden Klebstoff auf wenigstens einer Klebefläche des Modulträgers und/oder einer vom Schichtenaufbau abgewandten Substratfläche,
- Verbinden des Modulträgers durch die wenigstens eine Klebeschicht mit der Substratfläche,
- Aushärten(lassen) des Klebstoffs der Klebeschicht zur klebenden Befestigung des Modulträgers am Substrat.

Durch das erfindungsgemäße Verfahren kann ein Solarmodul technisch einfach und kostengünstig hergestellt werden, wobei eine potentialinduzierte Leistungsdegradation sicher und zuverlässig reduziert oder vermieden wird.

In einer bevorzugten Ausführungsform des erfindungsgemäßen Verfahrens werden ein oder mehrere Abstandshalter in den noch nicht ausgehärteten Klebstoff eingebracht. Die Abstandshalter sind jeweils dazu ausgebildet, die Klebefläche bei nicht ausgehärtetem Klebstoff der Klebeschicht in einem vorgebbaren Mindestabstand zur Substratfläche zu halten. Dadurch kann ein Solarmodul technisch einfach und kostengünstig hergestellt werden, wobei sichergestellt ist, dass die Modulträger von der rückseitigen Substratfläche in einem durch die Abstandshalter vorgebbaren Mindestabstand angeordnet sind.

In verfahrenstechnischer Hinsicht kann es von Vorteil sein, wenn die Abstandshalter in die wenigstens eine, bereits auf der Klebefläche des Modulträgers und/oder der rückseitigen Substratfläche aufgebrachte Klebeschicht eingebracht werden. Diese Maßnahme ermöglicht ein einfaches Aufsprühen bzw. Aufspritzen des Klebstoffs aus einer herkömmlichen Düse, wobei die Düse nicht auf die Abmessungen der Abstandshalter anzupassen ist. Vorzugsweise erfolgt das Einbringen der Abstandshalter in die Klebeschicht dadurch, dass die Abstandshalter durch einen Druckstoß pneumatisch eingeblasen werden, was technisch in besonders einfacher und kostengünstiger Weise realisierbar ist. Zudem können die Abstandshalter innerhalb der Klebeschicht an vorgebbaren Orten gezielt positioniert werden.

Des Weiteren erstreckt sich die Erfindung auf die Verwendung wenigstens einer Klebeschicht aus einem aushärtbaren und im ausgehärteten Zustand elektrisch hochisolierenden Klebstoffs zur Befestigung eines Modulträgers an einer rückseitigen Substratfläche eines Solarmoduls, insbesondere Dünnschichtsolarmoduls, wobei der elektrisch hochisolierenden Klebstoffs die potentialinduzierte Leistungsdegradation des Solarmoduls zuverlässig reduziert oder verhindert.

Die Erfindung wird nun anhand eines Ausführungsbeispiels näher erläutert, wobei Bezug auf die beigefügten Figuren genommen wird. Es zeigen:
- Figur 1: anhand einer schematischen (Teil-)Schnittdarstellung die Verklebung eines Modulträgers mit der rückseitigen Substratfläche eines Solarmoduls;
- Figur 2: eine schematische Draufsicht auf die Rückseite des Solarmoduls von Figur 1;
- Figur 3: eine schematische Schnittdarstellungen durch das Solarmodul von Figur 1;
- Figur 4A-4B: schematische Perspektivdarstellungen des Modulträgers des Solarmoduls von Figur 1;
- Figur 5: eine schematische Draufsicht auf die Rückseite eines alternativen Solarmoduls;
- Figur 6: ein Flussdiagramm des erfindungsgemäßen Verfahrens und
- Figur 7: Diagramm der potentialinduzierten Leistungsdegradation in Abhängigkeit des spezifischen elektrischen Widerstands des Klebstoff.

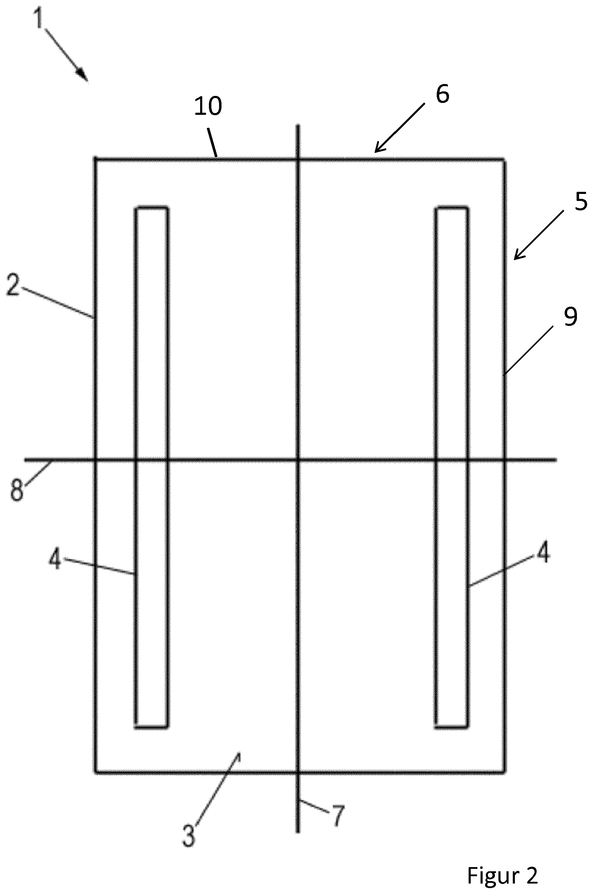

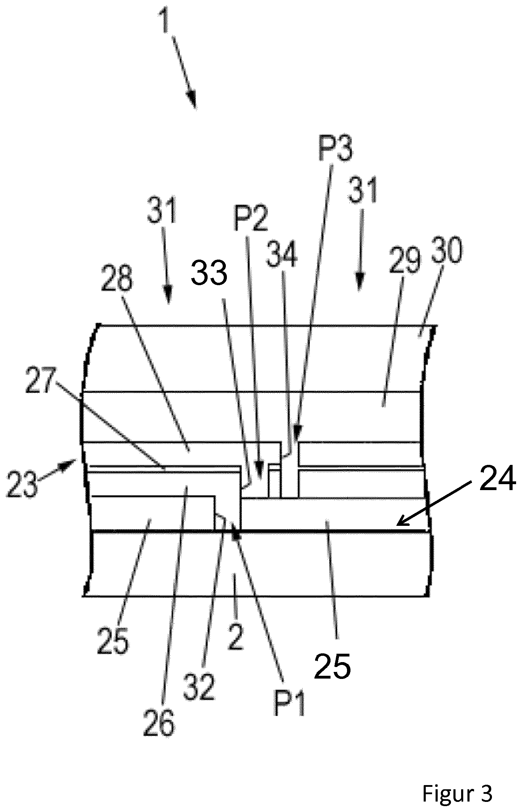

Es seien zunächst Figur 2 und Figur 3 betrachtet. Figur 2 zeigt eine schematische Ansicht der Modulrückseite ("Seite IV") eines insgesamt mit der Bezugszahl 1 bezeichneten Solarmoduls 1 am Beispiel eines Dünnschichtsolarmoduls. Wie üblich ist das Solarmodul 1 in Form eines in Aufsicht rechteckförmigen Flächenkörpers mit zwei parallelen Längsseiten 5 und hierzu senkrechten Querseiten 6 ausgebildet. Figur 3 zeigt eine Schnittdarstellung durch das Solarmodul 1.

Wie in Figur 3 erkennbar, hat das Solarmodul 1 einen der sogenannten Substratkonfiguration entsprechenden Aufbau. Das heißt es verfügt über ein elektrisch isolierendes (Träger-)Substrat 2 mit einem darauf aufgebrachten Schichtenaufbau 23 aus dünnen Schichten, der auf einer lichteintritts- bzw. vorderseitigen Substratfläche 24 ("Seite III") des Substrats 2 angeordnet ist. Das Substrat 2 besteht hier beispielsweise aus Glas und insbesondere aus Kalk-Natron-Glas, mit einer relativ geringen Lichtdurchlässigkeit, wobei gleichermaßen andere isolierende Materialien mit genügender Festigkeit, sowie inertem Verhalten gegenüber den durchgeführten Prozessschritten eingesetzt werden können.

Konkret umfasst der Schichtenaufbau 23 eine auf der vorderseitigen Substratfläche 24 angeordnete Rückelektrodenschicht 25, die beispielsweise aus einem lichtundurchlässigen Metall wie Molybdän (Mo) besteht und beispielsweise durch Aufdampfen auf das Substrat 2 aufgebracht werden kann. Die Rückelektrodenschicht 25 hat beispielsweise eine Schichtdicke von ca. 1 µm. Auf der Rückelektrodenschicht 25 ist eine Halbleiterschicht 26 abgeschieden, die einen Halbleiter enthält, dessen Bandabstand vorzugsweise in der Lage ist, einen möglichst großen Anteil des Sonnenlichts zu absorbieren. Die Halbleiterschicht 26 besteht beispielsweise aus einem p-leitenden Chalkopyrithalbleiter, beispielsweise einer Verbindung der Gruppe Cu(In,Ga)(S,Se)₂, insbesondere Natrium (Na)-dotiertes Kupfer-Indium-Diselenid (CInSe₂). Die Halbleiterschicht 26 hat beispielsweise eine Schichtdicke, die im Bereich von 1-5 µm liegt und beispielsweise ca. 2 µm beträgt. Auf der Halbleiterschicht 26 ist eine Pufferschicht 27 abgeschieden, die hier beispielsweise aus einer Einzellage Cadmiumsulfid (CdS) und einer Einzellage intrinsisches Zinkoxid (i-ZnO) besteht, was in den Figuren nicht näher dargestellt ist. Die Pufferschicht 27 hat beispielsweise eine geringere Schichtdicke als die Halbleiterschicht 26. Auf die Pufferschicht 27 ist eine Frontelektrodenschicht 28 beispielsweise durch Aufdampfen aufgebracht. Die Frontelektrodenschicht 28 ist für Strahlung im sichtbaren Spektralbereich transparent ("Fensterschicht"), um eine nur geringe Schwächung des einstrahlenden Sonnenlichts zu gewährleisten. Die transparente Frontelektrodenschicht 28, die verallgemeinernd als TCO-Schicht (TCO = Transparent Conductive Oxide) bezeichnet werden kann, basiert auf einem dotierten Metalloxid, beispielsweise n-leitendes, Aluminium (Al)-dotiertes Zinkoxid (ZnO). Durch die Frontelektrodenschicht 28 wird gemeinsam mit der Pufferschicht 27 und der Halbleiterschicht 26 ein Heteroübergang (d.h. Abfolge von Schichten vom entgegengesetzten Leitungstyp) gebildet. Die Schichtdicke der Frontelektrodenschicht 28 beträgt beispielsweise ca. 300 nm.

Zum Schutz vor Umwelteinflüssen ist auf der Frontelektrodenschicht 28 eine beispielsweise aus Polyvinylbutyral (PVB) oder Ethylenvinylacetat (EVA) bestehende Zwischenschicht 29 aufgebracht, die mit einer für Sonnenlicht transparenten Deckschicht 30, die beispielsweise aus extraweißem Glas mit geringem Eisengehalt besteht, verklebt ist.

Um die Gesamtmodulspannung zu erhöhen, ist die Modulfläche des Dünnschichtsolarmoduls 1 in eine Vielzahl einzelner Solarzellen 31 aufgeteilt, die in Serienschaltung miteinander verbunden sind. Zu diesem Zweck wird der Schichtenaufbau 23 unter Einsatz einer geeigneten Strukturierungstechnologie, beispielsweise Laserschreiben oder mechanische Bearbeitung (z.B. Abheben oder Ritzen), strukturiert. Eine solche Strukturierung umfasst für jede Solarzelle 31 typischerweise drei Strukturierungsschritte, die mit den Akronymen P1, P2, P3 abgekürzt werden. In einem ersten Strukturierungsschritt P1 wird die Rückelektrodenschicht 25 durch Erzeugen eines ersten Grabens 32 unterbrochen, was vor dem Aufbringen der Halbleiterschicht 26 erfolgt, so dass der erste Graben 32 durch das Halbleitermaterial dieser Schicht verfüllt wird. In einem zweiten Strukturierungsschritt P2 werden die Halbleiterschicht 26 und die Pufferschicht 27 durch Erzeugen eines zweiten Grabens 33 unterbrochen, was vor dem Aufbringen der Frontelektrodenschicht 28 erfolgt, so dass der zweite Graben 33 durch das elektrisch leitende Material dieser Schicht verfüllt wird. In einem dritten Strukturierungsschritt P3 werden die Frontelektrodenschicht 28, die Pufferschicht 27 und die Halbleiterschicht 26 durch Erzeugen eines dritten Grabens 34 unterbrochen, was vor dem Aufbringen der Zwischenschicht 29 erfolgt, so dass der dritte Graben 34 durch das isolierende Material dieser Schicht verfüllt wird. Alternativ wäre denkbar, dass der dritte Graben 34 bis zum Substrat 2 hinunter reicht. Durch die beschriebenen Strukturierungsschritte P1, P2, P3 werden seriell miteinander verschaltete Solarzellen 31 gebildet. Das Solarmodul 1 hat beispielsweise eine Klemmenspannung von typischerweise 60 V. Durch Serienverschaltung mehrerer Solarmodule 1 in einer photovoltaischen Anlage können sich - in Abhängigkeit von der Position in der Serienverschaltung - Spannungen zwischen dem Schichtenaufbau eines einzelnen Solarmoduls und der Bezugsmasse von über 1000 V ergeben.

Wie in Figur 2 erkennbar, sind auf der Modulrückseite, also auf der rückseitigen Substratfläche 3 des Substrats 2, welche vom Schichtenaufbau 23 zur Formung der Solarzellen abgewandt ist, zwei längliche Modulträger 4 befestigt. Die Modulträger 4 erstrecken sich jeweils entlang den Längsseiten 5 des Solarmoduls 1 und sind beispielsweise beiderseits einer Längsmittenebene 7 und symmetrisch zur Quermittenebene 8 des Solarmoduls 1 nahe dem Modullängsrand 9 angeordnet. Sie enden jeweils kurz vor dem Modulquerrand 10.

Durch die beiden länglichen Modulträger 4 kann eine mechanische Verstärkung des Solarmoduls 1 erreicht werden. Andererseits dienen die Modulträger 4 für eine Montage des Solarmoduls 1 durch Befestigen an einer ortsfest, verankerten Modulhalterung, welche typischerweise eine Mehrzahl beispielsweise aus Aluminium bestehender Tragschienen umfasst. Die beiden Modulträger 4 bestehen aus einem metallischen Material, beispielsweise Aluminium oder Stahl. Obgleich in Figur 2 zwei Modulträger 4 gezeigt sind, versteht es sich, dass das Solarmodul 1 gleichermaßen über eine größere oder kleinere Anzahl Modulträger 4 verfügen kann.

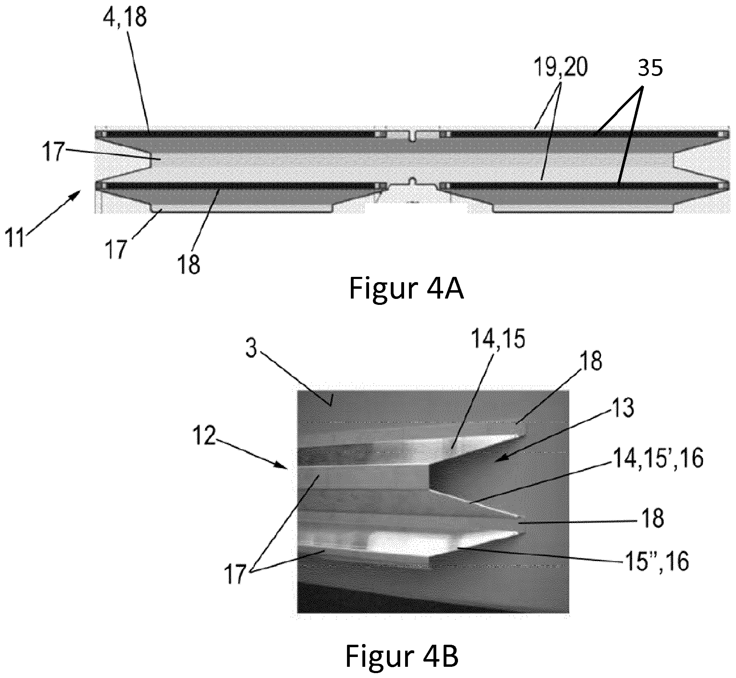

In den Figuren 4A und 4B ist ein einzelner Modulträger 4 näher dargestellt, wobei Figur 4A eine perspektivische Draufsicht auf die mit der rückseitigen Substratfläche 3 zu verbindenden Vorderseite 11 des Modulträger 4 und Figur 4B eine perspektivische Ansicht von Stirn- 13 und Rückseite 12 des Modulträgers 4 zeigt.

Demnach ist der Modulträger 4 als Profilteil ausgebildet und beispielsweise durch ein Metallumformverfahren aus einer Metallplatte hergestellt. Der Modulträger 4 kann zumindest gedanklich in zwei im Profil V-förmige Abschnitte 14, 16 zerlegt werden. So umfasst der Modulträger 4 einen ersten V-förmigen Abschnitt 14 mit zwei im spitzen Winkel zueinander angestellten Schenkeln 15, 15' die durch eine rückseitige Leiste 17 miteinander verbunden sind. Die beiden Schenkel 15, 15' sind jeweils mit einer entlang der Längsseiten 5 sich erstreckenden, vorderseitigen Leiste 18 verbunden, die seitlich vom Schenkel 15, 15' abgebogen ist. Die beiden vorderseitigen Leisten 18 stellen Klebeflächen 19 zur Befestigung des Modulträgers 4 am Substrat 2 bereit. Eine der beiden vorderseitigen Leisten 18 ist mit einem weiteren Schenkel 15" verbunden, welcher im spitzen Winkel zum benachbarten Schenkel 15' angestellt ist, wodurch gemeinsam mit dem benachbarten Schenkel 15' ein zweiter V-förmiger Abschnitt 16, welcher umgekehrt zum ersten V-förmigen Abschnitt 14 orientiert ist, gebildet wird. An diesem Schenkel 15" befindet sich eine weitere rückseitige Leiste 17. Durch die im Profil winkelige Struktur des Modulträgers 4 kann das Solarmodul 1 sehr effektiv versteift werden.

Wie in Figur 4A und 4B veranschaulicht, ist auf die beiden Klebeflächen 19 des Modulträgers 4 jeweils eine Kleberaupe 20 aufgebracht, welche zur Verklebung des Modulträgers 4 mit der rückseitigen Substratfläche 3 dient. Die Kleberaupen 20 erstrecken sich im Wesentlichen über die komplette Länge der Klebeflächen 19. Typischerweise ist der Klebstoff 35 im nicht ausgehärteten Zustand weich bzw. plastisch verformbar und geht durch Aushärten in einen harten, gegebenenfalls in gewissem Maße elastisch verformbaren, Zustand über in dem der Modulträger 4 mit dem Substrat 2 fest verbunden ist.

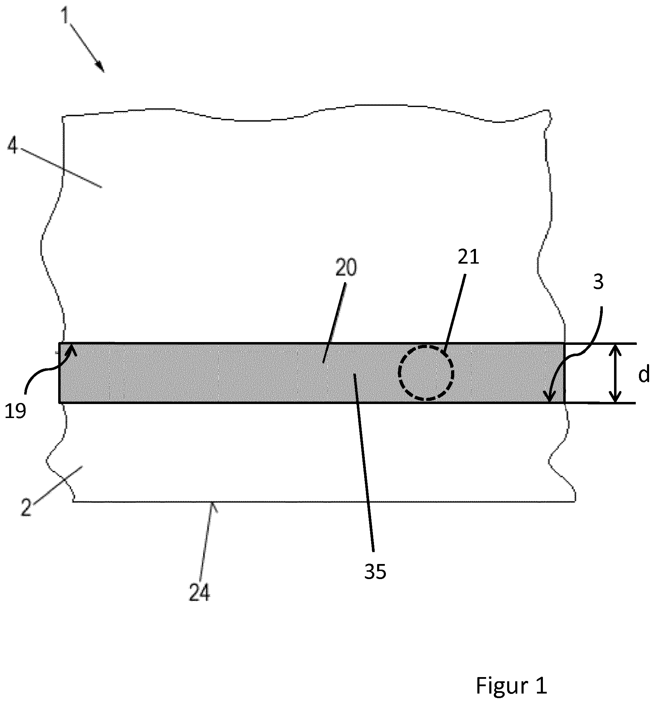

Es wird nun Bezug auf Figur 1 genommen, worin anhand einer schematischen (Teil-) Schnittdarstellung entlang der Längsseiten 5 des Solarmoduls 1 aus Figur 2 die Verklebung eines Modulträgers 4 mit der rückseitigen Substratfläche 3 des Solarmoduls 1 veranschaulicht ist. Der Schnitt ist durch eine Kleberaupe 20 aus einem Klebstoff 35 hindurch gelegt.

Die Klebeschicht 20 besteht aus einem aushärtbaren beziehungsweise im verklebten Zustand ausgehärteten elektrisch hochisolierenden Klebstoff 35, welcher einen hohen spezifischen elektrischen Widerstand von beispielsweise 6000 GOhm*cm aufweist. Die Dicke d der Klebeschicht 20 entspricht dem dargestellten Abstand zwischen Modulträger 4 und Substrat 2 und beträgt beispielsweise 2 mm.

In Figur 1 ist in einer optionalen Ausgestaltung in der Klebeschicht 20 ein Abstandshalter 21 in Form einer Kugel dargestellt. Es versteht sich, dass die Klebeschicht 20 auch mehrere Abstandshalter 21 aufweisen kann, die auch andere, beispielsweise stangenförmige, quaderförmige oder trapezoide Formen aufweisen können. Durch den gleichen Durchmesser der Abstandshalter 21 kann ein Mindestabstand zwischen den beiden Klebeflächen 19 des Modulträgers 4 und der rückseitigen Substratfläche 3 vorgegeben werden, wenn der Modulträger 4 zu deren Verklebung gegen das Substrat 2 gedrückt wird. Der Abstandshalter 21 besteht hier beispielsweise aus einem elastisch verformbaren Kunststoff, beispielsweise EPDM (Ethylen-Propylen-Dien-Kautschuk) mit einer Shore-Härte von 85 oder POM (Polyoxymethylen) mit einer Shore-Härte von 80. Um lokale Stromflüsse durch die Abstandshalter zu vermeiden, ist es besonders vorteilhaft, wenn die Abstandhalter einen spezifischen elektrischen Widerstand in der Größenordnung des elektrisch hochisolierenden Klebstoffs 35 oder größer aufweisen. Die Abstandshalter 21 sind bevorzugt härter als der nicht ausgehärtete Klebstoff 35, um die Abstandshalterfunktion erfüllen zu können. Sie sind jedoch nicht "zu hart", so dass Schädigungen durch lokale Punktbelastungen am gläsernen Substrat 2 vermieden werden können. Generell ist die Härte der Abstandshalter 21 hierbei geringer als jene des Substrats 2. Zudem entspricht die Härte der Abstandshalter 21 maximal jener des ausgehärteten Klebstoffs, um Punktbelastungen durch die Abstandshalter 21 bei starken Krafteinwirkungen in der Praxis, beispielsweise durch Schnee- oder Winddrucklast, zu vermeiden.

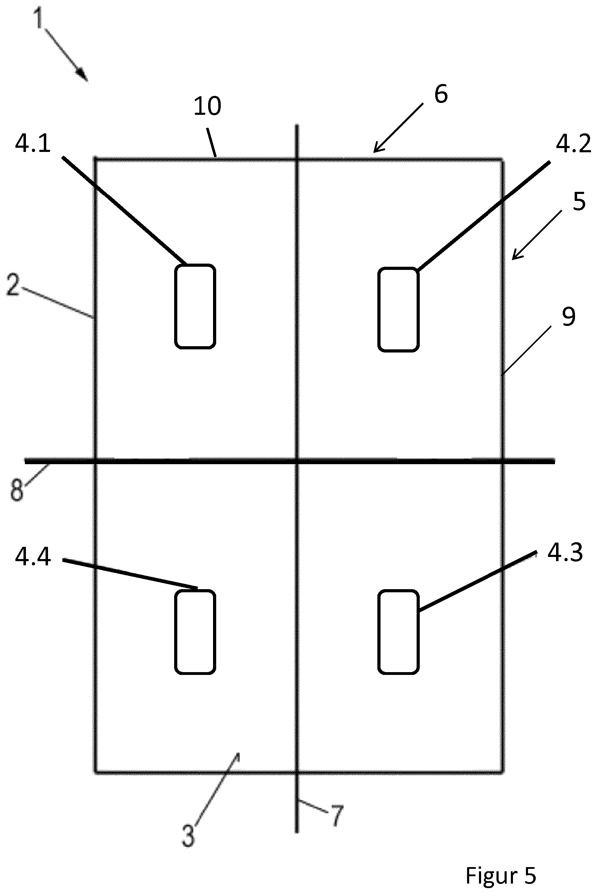

Figur 5 zeigt eine beispielhafte Ausgestaltung der rückseitigen Substratfläche 3 eines alternativen Solarmoduls 1. Wie in Figur 5 erkennbar, sind auf der Modulrückseite, also auf der rückseitigen Substratfläche 3 des Substrats 2, welche vom Schichtenaufbau 23 zur Formung der Solarzellen abgewandt ist, vier Modulträger 4.1,4.2,4.3,4.4 befestigt. Durch die Verwendung von Modulträgern 4.1,4.2,4.3,4.4 lässt sich eine sichere Befestigung bei einer guten Lastverteilung und geringerem Materialaufwand im Vergleich zum Beispiel aus Figur 2 erzielen.

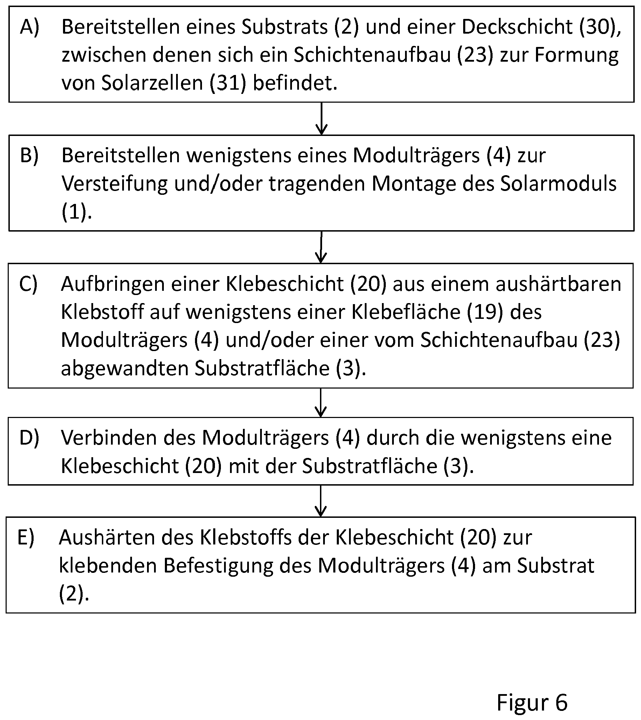

In Figur 6 ist ein Flussdiagramm des erfindungsgemäßen Verfahrens zur Herstellung eines Solarmoduls 1 mit einem elektrisch hochisolierten Modulträger 4 dargestellt.

In Experimenten wurde die potentialinduzierte Degradation unter standardisierten Testbedingungen gemessen. Der Test erfolgte in einer Klimakammer über eine Zeitdauer von 500 Stunden, wobei die Solarmodule 1 einer Temperatur von 95°C bei 85% relativer Feuchte ausgesetzt waren und die Solarmodule 1 dabei einmal am Tag auf - 40°C abgekühlt wurden.

Die Solarmodule 1 wurden elektrisch isolierend in der Klimakammer gelagert. Die Solarmodule 1 wurden an allen vorgesehenen Stellen und bei den Solarmodulen M3-M6 an den Modulträgern 4 auf der rückwärtigen Substratseite 3 des Substrats 2 geerdet. Die Solarmodule M1 und M2 diensten als Referenz und wiesen keine aufgeklebten Modulträger 4 auf. Die Solarmodule M1-M6 hatten eine Fläche von 30 cm x 30 cm. Der innere Schichtenaufbau 23 der Solarmodule 1 entsprach dem in Figur 3 dargestellten und oben beschriebenen Aufbau eines Dünnschichtsolarmoduls auf Basis eines Chalkopyrithalbleiters.

Bei den Solarmodulen M3-M6 wurde während der Tests eine Spannung von -1000 V zwischen den kurzgeschlossenen Modulanschlüssen und der Erdung angelegt. Die Solarmodule M1 und M2 wurden ohne Modulträger 4 auf der rückseitigen Substratfläche 3 und ohne Spannungsbeaufschlagung über 500 Stunden im Klimaschrank belassen und dienen als Referenz.

Die Klebstoffe A und B sind einkomponentige, über Alkoxygruppen vernetzende Silikonkleber mit einem spezifischen Widerstand von 6000 GOhm*cm beziehungsweise 1500 GOhm*cm. Klebstoff C ist ein spritzbarer Einkomponenten-Kleb- und -Dichtstoff auf Basis von Silan-modifizierten Polymeren, der durch Reaktion mit Feuchtigkeit zu einem elastischen Produkt vernetzt (aushärtet) mit einem spezifischen elektrisch Widerstand von 5 GOhm*cm.

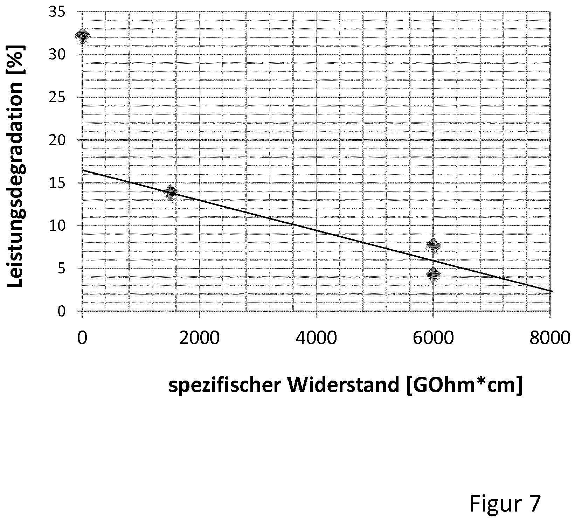

Die Ergebnisse der Experimente sind in Tabelle 1 und in Figur 7 dargestellt. Die angegebene Leistungsdegradation ist die Differenz der an Sonnensimulatoren nach Lightsoaking gemessenen Leistung vor und nach dem Test bezogen auf die Leistung vor dem Test.

Es zeigt sich eine deutliche Verringerung der Leistungsdegradation in Abhängigkeit des spezifischen elektrischen Widerstands des Klebstoffs 35 mit dem der Modulträger 4 an die rückseitigen Substratfläche 3 der Solarmodule M3-M6 befestigt sind. Im Falle des Klebstoffs A mit einem spezifischen Widerstand von 6000 GOhm*cm beträgt die Leistungsdegradation 4,4% und 7,8%. Im Falle des Klebstoffs B mit einem spezifischen Widerstand von 1500 GOhm*cm beträgt die Leistungsdegradation 14,0%. Im Falle des Klebstoffs C nach dem Stand der Technik mit einem spezifischen Widerstand von 5 GOhm*cm beträgt die Leistungsdegradation 32,3%. Es zeigt sich also eine unerwartete und drastische Abnahme in der Leistungsdegradation für erfindungsgemäße Klebstoffe A, B mit spezifischen Widerständen von größer oder gleich 1500 GOhm*cm im Vergleich zu Klebstoffen C nach dem Stand der Technik mit einem spezifischen Widerstand von 5 GOhm*cm.

**Tabelle 1: Leistungsdegradation in Abhängigkeit verschiedener Klebstoffe**

| Solarmodul | Klebstoff | Spez. Widerstand [GOhm*cm] | Spannung [V] | Leistungsdegradation [%] |
|---|---|---|---|---|
| M1 (Referenz) | Ohne | | 0 | 0,0 |
| M2 (Referenz) | Ohne | | 0 | 1,8 |
| M3 | A | 6000 | -1000 | 4,4 |
| M4 | A | 6000 | -1000 | 7,8 |
| M5 | B | 1500 | -1000 | 14,0 |
| M6 | C (Stand der Technik) | 5 | -1000 | 32,3 |

Wie sich aus vorstehender Beschreibung ergibt, stellt die Erfindung ein Solarmodul 1 zur Verfügung, das eine einfache, zuverlässige und kostengünstige Verklebung von Modulträgern 4 zur Stabilisierung oder tragenden Befestigung an einer Modulhalterung ermöglicht. Durch die erfindungsgemäße Verwendung eine elektrisch hochisolierenden Klebstoffs 35 wird die potentialinduzierte Degradation der Modulleistung deutlich reduziert. Dies war für den Fachmann unerwartet und überraschend.

### Bezugszeichenliste

- 1: Solarmodul
- 2: Substrat
- 3: rückseitige Substratfläche
- 4,4.1,4.2,4.3,4.4: Modulträger
- 5: Längsseite
- 6: Querseite
- 7: Längsmittenebene
- 8: Quermittenebene
- 9: Modullängsrand
- 10: Modulquerrand
- 11: Vorderseite
- 12: Rückseite
- 13: Stirnseite
- 14: erster V-förmiger Abschnitt
- 15, 15', 15": Schenkel
- 16: zweiter V-förmiger Abschnitt
- 17: rückseitige Leiste
- 18: vorderseitige Leiste
- 19: Klebefläche
- 20: Klebeschicht
- 21: Abstandshalter
- 23: Schichtenaufbau
- 24: vorderseitige Substratfläche
- 25: Rückelektrodenschicht
- 26: Halbleiterschicht
- 27: Pufferschicht
- 28: Frontelektrodenschicht
- 29: Zwischenschicht
- 30: Deckschicht
- 31: Solarzelle
- 32: erster Graben
- 33: zweiter Graben
- 34: dritter Graben
- 35: Klebstoff
- d: Dicke der Klebeschicht 20

## Patentansprüche

1. Solarmodul (1), mindestens umfassend
- ein Substrat (2) und eine Deckschicht (30), zwischen denen ein Schichtenaufbau (23) zur Formung von Solarzellen (31) angeordnet ist, und
- auf einer vom Schichtenaufbau (23) abgewandten Substratfläche (3) wenigstens ein Modulträger (4) aus einem metallischen Material zur Versteifung und/oder tragenden Montage des Solarmoduls (1), der mindestens eine Klebefläche (19) aufweist, die durch mindestens eine Klebeschicht (20) mit der Substratfläche (3) verklebt ist, **dadurch gekennzeichnet, dass** die Klebeschicht (20) einen ausgehärteten, elektrisch hochisolierenden Klebstoff (35) enthält, wobei der Klebstoff (35) einen spezifischen Widerstand von ≥1500 GOhm*cm, bevorzugt >4000 GOhm*cm, besonders bevorzugt von 5000 GOhm*cm bis 15000 GOhm*cm aufweist, wobei die Dicke (d) der Klebeschicht (20) von 1 mm bis 3 mm beträgt, wobei das Solarmodul keinen metallischen Rahmen aufweist und nur über den mindestens einen Modulträger (4) mit einer Erdung versehen ist.

2. Solarmodul (1) nach Anspruch 1, wobei der Klebstoff (35) einen Silikonkleber und bevorzugt einen einkomponentigen oder zweikomponentigen Silikonkleber enthält.

3. Solarmodul (1) nach einem der Ansprüche 1 bis 2, wobei die Dicke (d) der Klebeschicht (20) von 1,5 mm bis 2,5 mm beträgt.

4. Solarmodul (1) nach einem der Ansprüche 1 bis 3, wobei die Klebefläche (19) von 5% bis 20% und bevorzugt von 5% bis 10% der Substratfläche (3) beträgt.

5. Solarmodul (1) nach einem der Ansprüche 1 bis 4, wobei die maximale Spannungsdifferenz zwischen Schichtenaufbau (23) und Modulträger (4) größer oder gleich 900 V, bevorzugt von 900 V bis 2000 V und besonders bevorzugt von 1400 V bis 1600 V beträgt.

6. Solarmodul (1) nach einem der Ansprüche 1 bis 5, wobei das Substrat (2) Kalk-Natronglas enthält, bevorzugt mit einem minimalen Gehalt von 11 Gewichts-% Na₂O.

7. Solarmodul (1) nach einem der Ansprüche 1 bis 6, wobei der Schichtenaufbau (23) auf dem Substrat (2) angeordnet ist und mit einer Zwischenschicht (29) mit der Deckschicht (30) verbunden ist.

8. Solarmodul (1) nach einem der Ansprüche 1 bis 7, wobei die Klebeschicht (20) ein oder mehrere Abstandshalter (21) enthält, die jeweils dazu ausgebildet sind, die Klebefläche (19) bei nicht ausgehärtetem Klebstoff (35) der Klebeschicht (20) in einem vorgebbaren Mindestabstand zur Substratfläche (3) zu halten.

9. Verfahren zur Herstellung eines Solarmoduls (1) nach einem der Ansprüche 1 bis 8, mit den folgenden Schritten:
- Bereitstellen eines Substrats (2) und einer Deckschicht (30), zwischen denen sich ein Schichtenaufbau (23) zur Formung von Solarzellen (31) befindet,
- Bereitstellen wenigstens eines Modulträgers (4) zur Versteifung und/oder tragenden Montage des Solarmoduls (1),
- Aufbringen einer Klebeschicht (20) aus einem aushärtbaren Klebstoff auf wenigstens einer Klebefläche (19) des Modulträgers (4) und/oder einer vom Schichtenaufbau (23) abgewandten Substratfläche (3),
- Verbinden des Modulträgers (4) durch die wenigstens eine Klebeschicht (20) mit der Substratfläche (3),
- Aushärten des Klebstoffs der Klebeschicht (20) zur klebenden Befestigung des Modulträgers (4) am Substrat (2).

10. Verfahren nach Anspruch 9, wobei ein oder mehrere Abstandshalter (21) in den noch nicht ausgehärteten Klebstoff eingebracht werden, wobei die Abstandshalter (21) jeweils dazu ausgebildet sind, die Klebefläche (19) bei nicht ausgehärtetem Klebstoff der Klebeschicht (20) in einem vorgebbaren Mindestabstand zur Substratfläche (3) zu halten.

11. Verwendung wenigstens einer Klebeschicht (20) aus einem im ausgehärteten Zustand elektrisch hochisolierenden Klebstoff (35) zur Befestigung eines Modulträgers (4) an einer rückseitigen Substratfläche (3) eines Solarmoduls (1) nach einem der Ansprüche 1 bis 8, insbesondere eines Dünnschichtsolarmoduls, zur Verminderung einer potentialinduzierte Leistungsdegradation des Solarmoduls (1).

## Claims

1. Solar module (1), comprising at least
- a substrate (2) and a cover layer (30), between which a layer structure (23) for forming solar cells (31) is arranged, and
- on a substrate surface (3) facing away from the layer structure (23), at least one module support (4) made of metallic material for stiffening and/or supporting mounting of the solar module (1), which has at least one adhesive surface (19), which is bonded to the substrate surface (3) via at least one adhesive layer (20), **characterized in that** the adhesive layer (20) contains a hardened, electrically highly-insulating adhesive (35), wherein the adhesive (35) has a specific resistance of ≥1500 GOhm*cm, preferably >4000 GOhm*cm, particularly preferably of 5000 GOhm*cm to 15000 GOhm*cm, wherein the thickness (d) of the adhesive layer (20) is from 1mm to 3 mm, wherein the solar module has no metallic frame and is provided with grounding only via the at least one module support (4).

2. Solar module (1) according to claim 1, wherein the adhesive (35) contains a silicone adhesive and preferably a single component or two component silicone adhesive.

3. Solar module (1) according to one of claims 1 through 2, wherein the thickness (d) of the adhesive layer (20) is from 1.5 mm to 2.5 mm.

4. Solar module (1) according to one of claims 1 through 3, wherein the adhesive surface (19) is from 5% to 20% and preferably from 5% to 10% of the substrate surface (3).

5. Solar module (1) according to one of claims 1 through 4, wherein the maximum voltage difference between the layer structure (23) and the module support (4) is greater than or equal to 900 V, preferably from 900 V to 2000 V, and particularly preferably from 1400 V to 1600 V.

6. Solar module (1) according to one of claims 1 through 5, wherein the substrate (2) contains soda lime glass, preferably with a minimum content of 11 wt.-% Na₂O.

7. Solar module (1) according to one of claims 1 through 6, wherein the layer structure (23) is arranged on the substrate (2) and is bonded to the cover layer (30) via an intermediate layer (29).

8. Solar module (1) according to one of claims 1 through 7, wherein the adhesive layer (20) contains one or a plurality of spacers (21), each of which is implemented for the purpose of holding the adhesive surface (19) of the adhesive layer (20) at a pre-definable minimum distance from the substrate surface (3) while the adhesive (35) is unhardened.

9. Method for producing a solar module (1) according to any one of the claims 1 to 8, with the following steps:
- Preparing a substrate (2) and a cover layer (30), between which a layer structure (23) for forming solar cells (31) is situated,
- Preparing at least one module support (4) for stiffening and/or supporting mounting of the solar module (1),
- Applying an adhesive layer (20) made of a hardenable adhesive on at least one adhesive surface (19) of the module support (4) and/or on a substrate surface (3) facing away from the layer structure (23),
- Bonding the module support (4) to the substrate surface (3) via the at least one adhesive layer (20),
- Hardening the adhesive of the adhesive layer (20) for the adhesive attachment of the module support (4) on the substrate (2).

10. Method according to claim 9, wherein one or a plurality of spacers (21) are introduced into the not yet hardened adhesive, wherein the spacers (21) are in each case implemented for the purpose of holding the adhesive surface (19) at a pre-definable minimum distance from the substrate surface (3) while the adhesive of the adhesive layer (20) unhardened.

11. Use of at least one adhesive layer (20) made from an adhesive (35) electrically highly-insulating in the hardened state for attaching a module support (4) on a back substrate surface (3) of a solar module (1) according to any one of the claims 1 to 8, in particular a thin-film solar module, for reducing a potential-induced performance degradation of the solar module (1).

## Revendications

1. Module solaire (1), comprenant au moins
- un substrat (2) et une couche de recouvrement (30), entre lesquels est disposée une structure de couches (23) pour former des cellules solaires (31), et
- sur une surface de substrat (3) opposée à la structure en couches (23), au moins un support de module (4) en matériau métallique pour rigidifier et/ou soutenir le montage du module solaire (1), qui présente au moins une surface adhésive (19), qui est reliée à la surface de substrat (3) par l'intermédiaire d'au moins une couche adhésive (20), **caractérisé en ce que** la couche adhésive (20) contient un adhésif (35) durci à haute isolation électrique, où la couche adhésive (20) contient un adhésif (35) durci, hautement isolant électriquement, l'adhésif (35) présentant une résistance spécifique de >1500 GOhm*cm, de préférence >4000 GOhm*cm, de manière particulièrement préférée de 5000 GOhm*cm à 15000 GOhm*cm, l'épaisseur (d) de la couche adhésive (20) étant de 1 mm à 3 mm, le module solaire ne présentant pas de cadre métallique et n'étant mis à la terre que par le biais de l'au moins un support de module (4).

2. Module solaire (1) selon la revendication 1, dans lequel l'adhésif (35) contient un adhésif silicone et de préférence un adhésif silicone à un ou deux composants.

3. Module solaire (1) selon l'une des revendications 1 à 2, dans lequel l'épaisseur (d) de la couche adhésive (20) est comprise entre 1,5 mm et 2,5 mm.

4. Module solaire (1) selon l'une des revendications 1 à 3, dans lequel la surface adhésive (19) représente de 5% à 20% et de préférence de 5% à 10% de la surface du substrat (3).

5. Module solaire (1) selon l'une des revendications 1 à 4, dans lequel la différence de tension maximale entre la structure en couches (23) et le support (4) de module est supérieure ou égale à 900 V, de préférence de 900 V à 2000 V, et plus particulièrement de 1400 V à 1600 V.

6. Module solaire (1) selon l'une des revendications 1 à 5, dans lequel le substrat (2) contient du verre sodocalcique, de préférence avec une teneur minimale de 11 % en poids de Na₂O.

7. Module solaire (1) selon l'une des revendications 1 à 6, dans lequel la structure en couches (23) est disposée sur le substrat (2) et est liée à la couche de couverture (30) par une couche intermédiaire (29).

8. Module solaire (1) selon l'une des revendications 1 à 7, dans lequel la couche adhésive (20) contient une ou plusieurs entretoises (21), chacune d'entre elles étant mise en œuvre dans le but de maintenir la surface adhésive (19) de la couche adhésive (20) à une distance minimale prédéfinissable de la surface du substrat (3) pendant que l'adhésif (35) n'est pas durci.

9. Procédé de fabrication d'un module solaire (1) selon l'une quelconque des revendications 1 à 8, comprenant les étapes suivantes :
- Préparation d'un substrat (2) et d'une couche de recouvrement (30), entre lesquels se trouve une structure de couches (23) pour la formation de cellules solaires (31),
- Préparation d'au moins un support de module (4) pour rigidifier et/ou supporter le montage du module solaire (1),
- Application d'une couche adhésive (20) constituée d'un adhésif durcissable sur au moins une surface adhésive (19) du support de module (4) et/ou sur une surface de substrat (3) opposée à la structure en couches (23),
- Coller le support de module (4) à la surface du substrat (3) par l'intermédiaire de la au moins une couche adhésive (20),
- Durcissement de la colle de la couche adhésive (20) pour la fixation par collage du support de module (4) sur le substrat (2).

10. Procédé selon la revendication 9, dans lequel une ou plusieurs pièces d'écartement (21) sont introduites dans la colle non encore durcie, les pièces d'écartement (21) étant à chaque fois réalisées dans le but de maintenir la surface adhésive (19) à une distance minimale prédéfinissable de la surface du substrat (3) pendant que la colle de la couche adhésive (20) n'est pas durcie.

11. Utilisation d'au moins une couche de colle (20) constituée d'une colle (35) électriquement très isolante à l'état durci pour la fixation d'un support de module (4) sur une surface arrière de substrat (3) d'un module solaire (1) selon l'une quelconque des revendications 1 à 8, notamment d'un module solaire à couche mince, pour la réduction d'une dégradation de puissance potentiellement induite du module solaire (1).
